# EUROPÄISCHE PATENTSCHRIFT

(11) **EP 0 961 403 B1**
(45) Veröffentlichungstag und Bekanntmachung des Hinweises auf die Patenterteilung: **12.11.2003**
(21) Anmeldenummer: 99110187.4
(22) Anmeldetag: 26.05.1999
(51) Int. Cl.: H03G 7/00, G06G 7/24, H03F 3/45, H03F 1/30

(54) **Integrierte, temperaturkompensierte Verstärkerschaltung**
Integrated amplifying circuit comprising temperature compensation
Circuit amplificateur intégré compensé en température

(30) Priorität: 29.05.1998 DE 19824199
(43) Veröffentlichungstag der Anmeldung: 01.12.1999
(73) Patentinhaber: STMicroelectronics GmbH, 85630 Grasbrunn (DE)
(72) Erfinder: Viebach, Michael, 83049 Kolbermoor (DE)
(74) Vertreter: Hirsch, Peter, Dipl.-Ing.

(56) Entgegenhaltungen:
- DD-A- 215 222
- PATENT ABSTRACTS OF JAPAN vol. 015, no. 118 (E-1048), 22. März 1991 (1991-03-22) & JP 03 006906 A (FUJI ELECTRIC CO LTD), 14. Januar 1991 (1991-01-14)

## Beschreibung

Die Erfindung betrifft eine integrierte, temperaturkompensierte Verstärkerschaltung, die aus einem Eingangssignal mit Hilfe eines eine vorbestimmte Kennlinie aufweisenden ersten Bauelements ein der Kennlinie entsprechendes Ausgangssignal bildet.

Im folgenden wird speziell Bezug genommen auf einen logarithmischen Verstärker, wenngleich die Erfindung grundsätzlich anwendbar ist auf alle Verstärkerschaltungen, bei denen die das Verhältnis zweier Größen bestimmende Kennlinie eines Bauelements dazu benutzt wird, aus einem Eingangssignal ein Ausgangssignal zu bilden, welches von der Kennlinie abhängt.

Ein logarithmischer Verstärker wird auf verschiedenen Gebieten der Technik eingesetzt, unter anderem in Verbindung mit Lautstärkereglern von Audiogeräten. In solchen Geräten dient ein logarithmischer Verstärker dazu, den Verstellhub an das subjektive Lautstärkeempfinden des menschlichen Ohrs anzupassen.

Für logarithmische Verstärker werden im allgemeinen Dioden oder Bipolartransistoren verwendet, denn eine Diode hat (ebenso wie ein als Diode geschalteter Bipolartransistor) eine Strom-Spannungs-Kennlinie, die einer Exponentialfunktion entspricht, d.h., der Diodenstrom ändert sich bei linear ansteigender Diodenspannung etwa exponentiell. Bei eingeprägtem Strom ergibt sich also eine Diodenspannung, die etwa einer Logarithmusfunktion, d.h. der Umkehrfunktion einer Exponentialfunktion entspricht.

Üblicherweise wird in einem logarithmischen Verstärker, der als integrierte Schaltung (IC) ausgebildet ist, ein Eingangsstrom in einen Eingangsstromkreis eingespeist, in dem sich eine Diode (oder ein Transistor) befindet.

Parallel zu diesem Eingangsstromkreis ist ein Referenzstromkreis geschaltet, in dem sich eine Konstantstromquelle und ebenfalls eine Diode (bzw. ein Transistor) befinden, wobei die beiden Bauelemente in den beiden Stromzweigen möglichst identische Kennwerte aufweisen, insbesondere ein definiertes Verhältnis der aktiven Bauelementflächen. Zwischen den jeweiligen Eingangsknoten (z.B. Anoden) der Dioden ergibt sich eine vom Stromdichteverhältnis herrührende Differenzspannung. Diese Differenzspannung wird z.B. mit einem Differenzverstärker verstärkt, um das logarithmische Ausgangssignal zu gewinnen.

Ein Problem bei solchen Verstärkern ist die Abhängigkeit des Ausgangssignals von der Temperatur in dem IC-Chip. Abhängig von der Chiptemperatur erhält man für einen gegebenen Eingangsstrom unterschiedlich große Ausgangssignale.

Es sind verschiedene Temperaturkompensations-Maßnahmen bekannt. Mit Hilfe eines bezüglich des Chips externen Bauelements, z.B. einem einen definierten Temperaturkoeffizienten aufweisenden ohmschen Widerstand wird ein temperaturabhängiges Signal gewonnen, welches durch geeignete schaltungstechnische Maßnahmen so verarbeitet wird, daß das Ausgangssignal des integrierten logarithmischen Verstärkers temperaturunabhängig ist.

Die Beschaltung eines Chips mit externen Bauelementen ist grundsätzlich unerwünscht, da solche zusätzlichen Bauelemente beträchtlichen Platz auf der Schaltungsplatine beanspruchen. Außerdem erhöht sich der Fertigungsaufwand.

Statt eines externen Widerstands kann man auch von einem chip-internen Widerstand Gebrauch machen. Allerdings steht in den meisten integrierten Bipolar-Schaltungen kein Bauelement zur Verfügung, welches mit einem geeigneten Temperaturkoeffizienten behaftet ist. Im Gegenteil: Bei der Auslegung von integrierten Schaltungen ist man bestrebt, etwaige Temperaturkoeffizienten möglichst gering zu halten. Um nur kleine Temperaturkoeffizienten zur Temperaturkompensation eines logarithmischen Verstärkers verwenden zu können, sind komplizierte Schaltungen erforderlich.

Bei sämtlichen bekannten Temperaturkompensationen für logarithmische Verstärker ist die Übereinstimmung zwischen dem Temperaturkoeffizienten des Verstärkers selbst und dem zur Kompensation herangezogenen Temperaturkoeffizienten eines anderen Bauteils keineswegs ideal.

Aus der JP-3-6906 A ist eine temperaturkompensierte Verstärkerschaltung für logarithmische Verstärkung bekannt. Als erstes Bauelement befindet sich eine Diode in dem Eingangsstromkreis, in dem dazu parallelgeschalteten Referenzstromzweig befindet sich ebenfalls eine Diode. Das in den Eingangsstromkreis eingegebene Eingangssignal legt die von einer an den Referenzstromzweig angeschlossenen Konstantstromquelle gelieferte Stromstärke fest. Ein Differenzverstärker bildet aus den Spannungen an den Dioden ein Differenzsignal, welches für die Temperaturkompensation herangezogen wird. Die Temperaturkompensation geschieht mit Hilfe eines Differenzverstärkers, dessen nicht-invertierendem Eingang das Differenzsignal der Diodenspannungen zugeführt wird, und dessen invertierender Eingang an eine veränderliche Spannungsquelle angeschlossen ist, deren Spannungswert von der Spannung an der Diode im Eingangsstromkreis abhängt.

Aus der DD 215 222 ist eine logarithmisch arbeitende Strom-Spannungs-Wandlerschaltung bekannt, bei der zur Umsetzung des Eingangsstroms in den Ausgangsstrom im Rückkopplungszweig eines OP-Verstärkers ein nicht-lineares Bauelement angeordnet ist. Zur Differenzbildung und Temperaturkompensation sind an den Ausgang dieser Anordnung zwei ebenfalls nicht-lineare Bauelemente in zwei parallelen Zweigen mit jeweils einer zugehörigen Stromquelle angeordnet. Die beiden parallelen Zweige sind an den invertierenden bzw. den nicht-invertierenden Eingang eines Ausgangs-Operationsverstärkers angeschlossen, wobei in dem einen Zweig ein lineares Dämpfungsglied liegt. Bei geeigneter Dimensionierung der Bauelemente erfolgt eine temperaturabhängige Verstärkung der an den nichtlinearen Bauelementen gebildeten, temperaturabhängigen Differenz-Spannung, also eine Temperaturkompensation.

Der Erfindung liegt die Aufgabe zugrunde, eine Verstärkerschaltung der eingangs genannten Art anzugeben, bei der unter Verzicht auf externe Bauelemente mit vergleichsweise einfachen schaltungstechnischen Mitteln eine gute Kompensation erreicht wird.

Gelöst wird diese Aufgabe bei einer integrierten Verstärkerschaltung der oben genannten Art, die folgende Merkmale aufweist:
a) parallel zu einem das erste Bauelement enthaltenden Eingangsstromzweig ist ein ebenfalls ein solches, zweites Bauelement enthaltender Referenzstromzweig geschaltet, der einen konstanten Strom zuführt;
b) ein erster Differenzverstärker verstärkt einen aus der ersten Differenzspannung zwischen den Eingangsknoten der beiden Bauelemente abgeleiteten Wert, um das Ausgangssignal des Verstärkers zu bilden;
c) zur Temperaturkompensation sind zwei jeweils einen konstanten Strom führende Stromzweige mit je einem Bauelement mit identischer Kennlinie wie das erste und das zweite Bauelement, und ein zweiter Differenzverstärker vorgesehen, der einen aus der zweiten Differenzspannung zwischen den Eingangsknoten der beiden Bauelemente in den beiden Stromzweigen abgeleiteten Wert verstärkt, um ein Fehlersignal zu bilden;
d) für die erste und die zweite Differenzspannung ist je ein steuerbarer Spannungsteiler mit Teilspannungsabgriff vorgesehen, dem als Steuersignal das Fehlersignal zugeführt wird, und
e) der erste und der zweite Differenzverstärker sind an den Teilspannungsabgriff des zugehörigen steuerbaren Spannungsteilers angeschlossen.

Bei der erfindungsgemäßen Verstärkerschaltung sind also zwei Paare von die bestimmte Kennlinie aufweisenden Bauelementen vorgesehen, ein Paar ist dem eigentlichen Verstärker zugeordnet, der das Ausgangssignal liefert, das andere Paar von Bauelementen dient zur Temperaturkompensation. Dieses zur Temperaturkompensation dienende Paar von Bauelementen, die jeweils von einem definierten konstanten Strom durchflossen werden, liefern ebenfalls eine Spannungsdifferenz, die durch den steuerbaren Spannungsteiler geteilt wird. Der zweite Differenzverstärker vergleicht die Ausgangsspannung des ihm zugehörigen steuerbaren Spannungsteilers mit einer temperaturunabhängigen Referenzspannung, so daß das Teilungsverhältnis dieses Spannungsteilers ständig so geregelt wird, daß die temperaturabhängige Differenzspannung an dem gesamten steuerbaren Spannungsteiler eine temperaturunabhängige Ausgangsspannung an den Teilspannungsabgriff liefert.

Da das von dem zweiten Differenzverstärker gelieferte Fehlersignal sowohl den steuerbaren Spannungsteiler in dem zur Temperaturkompensation dienenden Schaltungsteil als auch den steuerbaren Spannungsteiler im eigentlichen Verstärkerteil einstellt, ist die Spannung an dem Teilspannungsabgriff im Verstärkerteil selbst temperaturunabhängig, und damit ist das von dem ersten Differenzverstärker gebildete Ausgangssignal temperaturunabhängig.

Die erfindungsgemäße Schaltung ist relativ einfach aufgebaut und enthält wenige Schaltungskomponenten.

In einer bevorzugten Ausführungsform sind die Bauelemente Dioden oder Bipolartransistoren, d.h. die Verstärkerschaltung erhält ein logarithmisches Verhalten. In einer bevorzugten Ausführungsform der Erfindung wird der steuerbare Spannungsteiler in jedem der beiden Spannungsteiler durch einen festen Ohmschen Widerstand und einen MOSFET gebildet, dessen Gate das Fehlersignal zugeführt wird, und dessen Drain-Source-Strecke einen veränderlichen Widerstand darstellt, der von dem am Gate liegenden Fehlersignal abhängt.

In einer speziellen Ausführungsform ist vorgesehen, daß der erste und der zweite Differenzverstärker jeweils an die beiden Anschlüsse des veränderlichen Widerstands angeschlossen sind, wobei in dem Eingangszweig des zweiten Differenzverstärkers eine temperaturunabhängige Konstantspannungsquelle liegt. Hierdurch wird in dem zur Temperaturkompensation dienenden Schaltungsteil von dem zweiten Differenzverstärker die Ausgangsspannung des zugehörigen Spannungsteilers mit der temperaturunabhängigen Konstantspannung verglichen. Erhöht sich die Spannung am Spannungsteiler, also auch am veränderlichen Widerstand, so liefert der zweite Differenzverstärker ein entsprechend höheres Ausgangssignal, wodurch der veränderliche Widerstand etwas gesenkt wird, um die z.B. auf eine Temperaturerhöhung zurückgehende erhöhte Spannung an dem veränderlichen Widerstand wieder auszugleichen. Der gleiche Vorgang findet bei dem veränderlichen Widerstand des Spannungsteilers im eigentlichen Verstärkerteil der Schaltung statt, so daß das Ausgangssignal des ersten Differenzverstärkers temperaturunabhängig ist.

Die erfindungsgemäße Schaltung hat den besonderen Vorteil, daß sie mit sehr wenig Bauteilen auskommt. Man kann den eigentlichen Verstärkerteil mit Eingangsstromkreis und Referenzstromkreis einerseits und den Schaltungsteil für die Temperaturkompensation mit seinen beiden Stromkreisen andererseits jeweils separat ausbilden. In einer besonders bevorzugten Ausgestaltung der Erfindung ist allerdings vorgesehen, daß einer der zwei für die Temperaturkompensation vorgesehenen Stromzweige identisch ist mit dem Referenzstromzweig des eigentlichen Verstärkerteils. Bei dieser Schaltung sind also drei Stromzweige parallel geschaltet, wobei die Stromzweige Bauteile enthalten, deren Kennlinien identisch sind: Den Eingangsstromkreis, den Referenzstromkreis und einen weiteren Stromkreis, wobei der Eingangsstromkreis und der Referenzstomkreis ein Paar bilden, welches im folgenden auch als "Eingangspaar" bezeichnet wird, und der Referenzstromzweig und der weitere Stromzweig ein Paar bilden, welches im folgenden auch als "Referenzpaar" oder "Kompensationspaar" bezeichnet wird.

Damit das Referenzpaar eine signifikante Differenzspannung zwischen den beiden Eingangsknoten der Bauelemente (Dioden) liefert, sieht die Erfindung in einer bevorzugten Ausführungsform vor, daß das Bauelement in einem der für die Temperaturkompensation vorgesehenen Stromzweige bei gleichem Strom (I1 = I2) eine größere definierte Bauelementfläche aufweist als das Bauelement in dem anderen dieser Stromzweige. Wenn in den beiden Stromzweigen des "Referenzpaares" gleich große Ströme fließen, bestimmt das Verhältnis der aktiven Bauelementflächen dieser Zweige die Differenzspannung mit. Bei einem Flächenverhältnis von bspw. 10:1 mit der größeren Fläche in dem nicht zum "Eingangspaar" gehörigen Bauelement erhält man eine relativ große Differenzspannung, die günstig für eine gute Temperaturkompensation ist. Maßgebend für die Bildung der Differenzspannung ist letztlich das Stromdichteverhältnis in den beiden Bauelementen des Referenzpaares. Die gleiche Wirkung kann bei gleichen Flächen (a2 = a3) auch durch ungleiche Ströme von bspw. 1:10 erreicht werden.

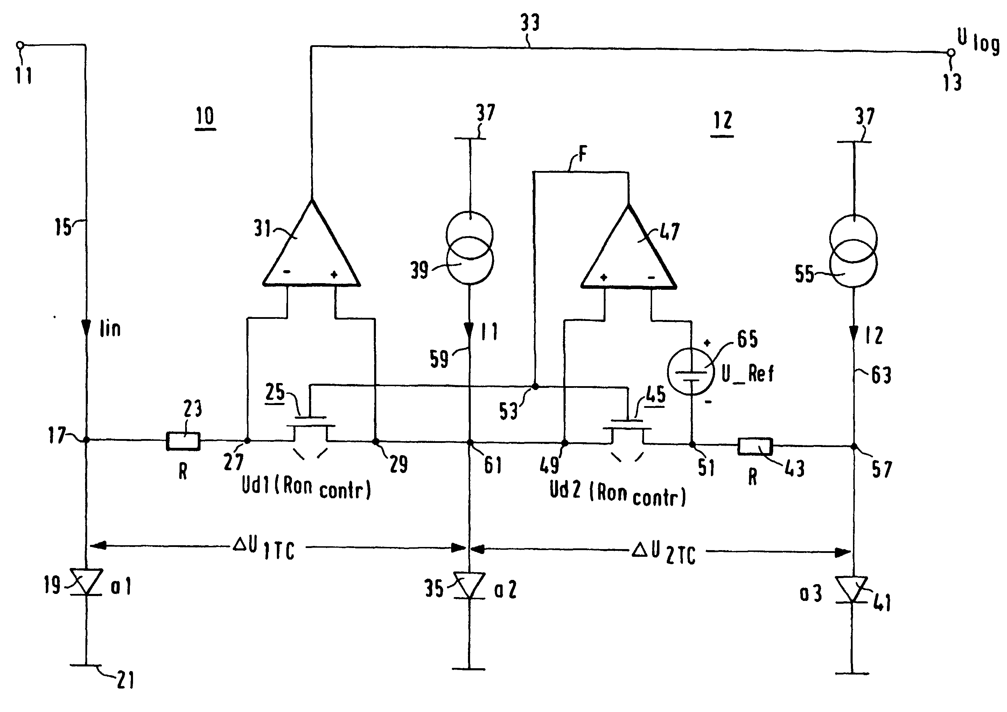

Im folgenden wird eine Ausführungsform der Erfindung anhand der Zeichnung näher erläutert. Die einzige Figur zeigt eine Schaltungsskizze eines voll integrierten logarithmischen Verstärkers mit Temperaturkompensation.

An einen Stromeingang 11 wird ein Eingangsstrom Lein gelegt, der von dem links in der Figur allgemein mit 10 bezeichneten Verstärkerteil in eine Ausgangsspannung Ulog umgewandelt wird, die am Ausgang 13 abgenommen wird, und die von dem Eingangsstrom Iein entsprechend einer Logarithmusfunktion abhängt.

Zunächst soll der Verstärkerteil 10 im einzelnen beschrieben werden. Der durch einen Eingangsstromzweig 15 fließende Eingangsstrom Iein gelangt über einen Knoten 17 an die Anode einer Diode 19, deren Kathode auf Schaltungsmasse (GND) 21 liegt.

Parallel zu dem durch die Eingangsleitung 15 gebildeten Eingangsstromkreis liegt ein Referenzstromkreis 59 zwischen einer Spannungsversorgung 37 und Schaltungsmasse (GND). Der Referenzstromzweig 59 enthält eine Konstantstromquelle 39 und eine Diode 35. An der Diode 35 fällt aufgrund des konstanten Stroms I1 eine lediglich temperaturabhängige Spannung ab. Die Spannung an der Diode 19 ändert sich mit sich änderndem Eingangsstrom Iein, und der Temperatur.

Die aktive Bauelementfläche a1 der Diode 19 ist genauso groß wie die Fläche a2 der Diode 35, so daß für den Fall, daß der Eingangsstrom Lein genauso groß ist wie der Strom I1, zwischen den beiden Anoden der Dioden 19 und 35 eine Differenzspannung ΔU_{1TC} = 0 existiert. Bei von dem genannten Wert abweichenden Eingangsstrom lein ergibt sich ein endlicher Wert für die Differenzspannung ΔU_{1TC}. Der Index "TC" steht für "Temperaturcoeffizient" und ist als Hinweis darauf zu verstehen, daß die Differenzspannung temperaturabhängig ist.

Die Differenzspannung ΔU_{1TC} wird von einem Spannungsteiler geteilt, der einen festen ohmschen Widerstand 23 und einen veränderlichen ohmschen Widerstand 25 enthält, dessen Wert Ron_{contr.} beträgt.

Bei dieser Ausführungsform ist der veränderliche Widerstand als MOSFET (MOS-Feldeffekttransistor) ausgebildet. Die Spannungsdifferenz Ud1 zwischen Source und Drain des als MOSFET ausgebildeten veränderlichen Widerstands 25 wird von einem Differenzverstärker 31 verstärkt. Das Ausgangssignal 33 des Differenzverstärkers 31 gelangt als Ausgangssignal Ulog an den Ausgang 13.

Rechts in der Figur ist ein Kompensationsschaltungsteil 12 dargestellt.

Der Kompensationsschaltungsteil 12 besteht aus dem bereits erwähnten Referenzstromzweig 59 und einem weiteren, zu letzterem parallel geschalteten Stromzweig 63, der ebenso wie der Referenzstromzweig eine Konstantstromquelle 55 und eine Diode 41 enthält. In dem Stromzweig 63 fließt ein konstanter Strom 12. Die aktive Bauelementfläche a3 der Diode 41 ist zehnmal so groß wie die Fläche a2 der Diode 35.

Zweckmäßigerweise sind die Ströme I1 und I2 in den Stromzweigen 59 und 63 oder die Flächen a2 und a3 gleich groß. Normiert man die erwähnten Flächen a1, a2 und a3 auf a1, und normiert man die Ströme auf I1, so erhält man folgende Werte.
1) a1 = a2 = 1; a3 = 10
2) I1 = I2 = 1; und
3) I1/a2 : I2/a3 = 10

Die Fläche a3 ist deshalb um einen definierten Faktor größer als a2, weil man dadurch in den genannten Stromwerten eine vergleichsweise hohe Differenzspannung ΔU_{2TC} an dem "Referenzpaar" erhält.

Alternativ möglich ist es, die Flächen gleich groß und die Ströme unterschiedlich groß zu wählen, dabei erhält man folgende Werte:
4) a1 = a2 = a3 = 1
5) I1 = 10 : I2 = 1
6) I1/a2 : I2/a3 = 10
Die Differenzspannung ΔU_{2TC} wird von einem Spannungsteiler geteilt, der einen festen Widerstand 43 und einen veränderlichen steuerbaren Widerstand 45 enthält, dessen Wert mit Ron_{contr} bezeichnet ist..

Der Spannungsteiler in dem "Eingangspaar" ist identisch ausgebildet wie der Spannungsteiler in dem "Referenzpaar".

Weiterhin befinden sich in dem Kompensationsschaltungsteil 12 ein Differenzverstärker 47, der die Ausgangsspannung des Spannungsteilers mit einer temperaturunabhängigen konstanten Referenzspannung U_{Ref} vergleicht, die auf dem Chip in Form einer Konstantspannungsquelle 65 verfügbar ist. Der Differenzverstärker 47 liefert an seinem Ausgang ein Fehlersignal F, welches mit jedem Gate der als MOSFET ausgebildeten Widerstände über einen Knoten 53 verbunden ist.

Das "Referenzpaar" rechts in der Schaltung arbeitet genauso wie das "Eingangspaar" links in der Schaltungsskizze. Steigt die Temperatur der gesamten Schaltung an, so würde ohne Kompensation die Differenzspannung ΔU_{1TC} zu einer erhöhten Spannung an dem veränderlichen Widerstand 25 führen, mithin zu einem verfälschten Ausgangssignal. Im folgenden wird die durch die erfindungsgemäße Schaltung erreichte Temperaturkompensation erläutert.

Im Falle einer Temperaturerhöhung ändert sich nicht nur der Betrieb des eigentlichen Verstärkerteils 10, wie oben erläutert wurde, sondern gleichermaßen auch der Betrieb des Kompensationsteils 12. Angenommen, durch eine Temperaturerhöhung steige die zweite Differenzspannung ΔU_{2TC} an. Zunächst hätten der feste Widerstand 43 und der veränderliche Widerstand 45 des Spannungsteilers die Tendenz, beide eine höhere Spannung zu haben. Allerdings wird die erhöhte Spannung am Knoten 49 von dem Differenzverstärker 47 zu einem erhöhten Fehlersignal F verarbeitet, welches über den Knoten 53 an das Gate des als MOSFET ausgebildeten veränderlichen Widerstands 45 gelangt. Durch Erhöhung der Gatespannung wird der Feldeffekttransistor etwas mehr geöffnet, der Widerstand zwischen Source und Drain sinkt, und die Spannung nimmt ab (bei gleichzeitiger Erhöhung der Spannung an dem festen Widerstand 43).

Die Spannungsdifferenz Ud2 an dem veränderlichen Widerstand 45 ist also temperaturunabhängig. Genauso temperaturunabhängig ist damit die Spannungsdifferenz Ud1 an dem veränderlichen Widerstand 25, da dessen Gate ebenfalls das Fehlersignal F als Steuersignal empfängt. Weil die Spannung Ud1 temperaturunabhängig ist (mit anderen Worten: keinen Temperaturkoeffizienten aufweist), ist auch das von dem Differenzverstärker 31 gebildete Ausgangssignal auf der Leitung 33 und am Ausgang der Schaltung 13 temperaturunabhängig.

In einer nicht ganz so günstigen, abgewandelten Ausführungsform könnte der hier für das "Eingangspaar" einerseits und das "Referenzpaar" andererseits gemeinsam verwendete Stromzweig 59 auch separat für Eingangspaar und Referenzpaar ausgebildet werden.

Anstelle der Dioden 19, 35 und 41 könnten auch Transistoren verwendet werden. Grundsätzlich kann man anstelle der Dioden jedes Bauelement einsetzen, welches eine bestimmte Kennlinie hat, durch die die Veränderung des Ausgangssignals am Ausgang 13 in Abhängigkeit des Eingangssignals am Eingang 11 festgelegt wird. Bei der oben erläuterten Schaltung wird zwar die Differenzspannung ΔU_{1TC} (ebenso wie die zweite Differenzspannung ΔU_{2TC}) durch den Spannungsteiler vermindert, so daß der Differenzverstärker 31 ein vergleichsweise kleineres Eingangssignal erhält, allerdings ist dieses Eingangssignal temperaturunabhängig.

## Patentansprüche

1. Integrierte, temperaturkompensierte Verstärkerschaltung, die aus einem Eingangssignal (lein) mit Hilfe eines eine vorbestimmte Kennlinie aufweisenden ersten Bauelements (19) ein der Kennlinie entsprechendes Ausgangssignal (Ulog) bildet, enthaltend folgende Merkmale:
a) parallel zu einem das erste Bauelement enthaltenden Eingangsstromzweig (15) ist ein ebenfalls ein solches, zweites Bauelement (35) enthaltender Referenzstromzweig (59) geschaltet, der einen konstanten Strom (I1) zuführt;
b) ein erster Differenzverstärker (31) verstärkt einen aus der ersten Differenzspannung (ΔU_{1TC}) zwischen den Eingangsknoten (17, 29) der beiden Bauelemente (19, 35) abgeleiteten Wert (Ud1), um das Ausgangssignal (Ulog) des Verstärkers (10) zu bilden;
c) zur Temperaturkompensation sind zwei jeweils einen konstanten Strom (I1, I2) führende Stromzweige (59, 63) mit je einem Bauelement (35, 41) mit identischer Kennlinie wie das erste und das zweite Bauelement, und ein zweiter Differenzverstärker (47) vorgesehen, der einen aus der zweiten Differenzspannung (ΔU_{2TC}) zwischen den Eingangsknoten (61, 57) der beiden Bauelemente (35, 41) in den beiden Stromzweigen (59, 63) abgeleiteten Wert (Ud2) verstärkt, um ein Fehlersignal (F) zu bilden;
d) für die erste und die zweite Differenzspannung ist je ein steuerbarer Spannungsteiler (23, 25; 43, 45) mit Teilspannungsabgriff (27/29; 49/51) vorgesehen, dem als Steuersignal das Fehlersignal (F) zugeführt wird, und
e) der erste und der zweite Differenzverstärker (31, 47) sind an den Teilspannungsabgriff des zugehörigen steuerbaren Spannungsteilers (27/29, 49/51) angeschlossen.

2. Verstärkerschaltung nach Anspruch 1, **dadurch gekennzeichnet, daß** der Verstärker ein logarithmischer Verstärker (10) ist und die eine vorbestimmte Kennlinie aufweisenden Bauelemente (19, 35, 41) Dioden oder Bipolartransistoren sind.

3. Verstärkerschaltung nach Anspruch 1 oder 2, **dadurch gekennzeichnet, daß** jeder steuerbare Spannungsteiler als veränderlichen Widerstand (25, 45) einen MOSFET enthält, dessen Gate das Fehlersignal (F) empfängt.

4. Verstärkerschaltung nach Anspruch 1 oder 2, bei der jeder steuerbare Spannungsteiler aus mehreren MOSFET's gebildet ist, deren Gates das Fehlersignal (F) empfangen.

5. Verstärkerschaltung nach einem der Ansprüche 1 bis 4, **dadurch gekennzeichnet, daß** der erste und der zweite Differenzverstärker (31, 47) jeweils an die Teilspannungsabgriffe des steuerbaren Spannungsteilers (27/29, 49/51) angeschlossen sind, wobei in dem einen Eingangszweig des zweiten Differenzverstärkers (47) eine temperaturunabhängige Konstantspannungsquelle (65) liegt.

6. Verstärkerschaltung nach einem der Ansprüche 1 bis 5, **dadurch gekennzeichnet, daß** einer der zwei für die Temperaturkompensation vorgesehenen Stromzweige (59, 63) identisch ist mit dem Referenzstromzweig (59).

7. Verstärkerschaltung nach einem der Ansprüche 1 bis 6, **dadurch gekennzeichnet, daß** das Bauelement (41) in einem der für die Temperaturkompensation vorgesehenen Stromkreise eine größere oder kleinere definierte Bauelementfläche (a3) aufweist als das Bauelement (35) in dem anderen dieser Stromkreise.

## Claims

1. An integrated, temperature-compensated amplifier circuit forming of an input signal (Iin), by means of a first component having (19) a predetermined characteristics, an output signal (Ulog) corresponding to said characteristics, said circuit comprising the following features:
a) parallel to an input current branch (15) containing the first component, there is connected a reference current branch (59) also containing such a, second, component (35) and supplying a constant current (I1);
b) a first differential amplifier (31) amplifies a value (Ud1) derived from the first differential voltage (ÄU_{1TC}) between the input nodes (17, 29) of the two components (19, 35), in order to form the output signal (Ulog) of the amplifier (10);
c) for temperature compensation, there are provided two current branches (59, 63) each carrying a constant current (I1, I2) and each having a component (35, 41) with identical characteristics as the first and second components, as well as a second differential amplifier (47) amplifying a value (Ud2) derived from the second differential voltage (ΔU_{2TC}) between the input nodes (61, 57) of the two components (35, 41) in the two current branches (59, 63), in order to form an error signal (F);
d) for the first and second differential voltages, there is provided one controllable voltage divider (23, 25; 43, 45) each, having a partial voltage tapping means (27/29; 49/51) and being fed with the error signal (F) as control signal, and
e) the first and second differential amplifiers (31, 47) are connected to the partial voltage tapping means (27/29, 49/51) of the associated controllable voltage divider.

2. The amplifier circuit of claim 1,
**characterized in that** the amplifier is a logarithmic amplifier (10) and the components (19, 35, 41) having a predetermined characteristics are diodes or bipolar transistors.

3. The amplifier circuit of claim 1 or 2,
**characterized in that** each controllable voltage divider comprises as variable resistor (25, 45) a MOSFET the gate of which has the error signal (F) supplied thereto.

4. The amplifier circuit of claim 1 or 2,
**characterized in that** each controllable voltage divider is formed of a plurality of MOSFETs the gates of which have the error signal (F) supplied thereto.

5. The amplifier circuit of any of claims 1 to 4,
**characterized in that** the first and the second differential amplifier (31, 47) are each connected to the partial voltage tapping means of the controllable voltage divider (27/29, 49/51), with a temperature-independent constant voltage source (65) being present in one input branch of the second differential amplifier (47).

6. The amplifier circuit of any of claims 1 to 5,
**characterized in that** one of the two current branches (59, 63) provided for temperature compensation is identical with the reference current branch (59).

7. The amplifier circuit of any of claims 1 to 6,
**characterized in that** the component (41) in one of the current circuits provided for temperature compensation has a greater or a smaller defined component area (a3) than the component (35) in the other one of these circuits.

## Revendications

1. Circuit amplificateur intégré à compensation de température qui, à partir d'un signal d'entrée (Iein), à l'aide d'un premier composant (19) présentant une courbe caractéristique prédéterminée, forme un signal de sortie (Ulog) correspondant à la courbe caractéristique, présentant les caractéristiques suivantes :
a) parallèlement à une branche de circuit de courant d'entrée (15) comprenant le premier composant est branchée une branche de circuit de courant de référence (59) qui comprend un second composant (35) de même type, et délivre un courant constant (I1) ;
b) un premier amplificateur différentiel (31) amplifie une valeur (Ud1) dérivée de la première tension différentielle (ΔU_{1TC}) entre les noeuds d'entrée (17, 29), pour former le signal de sortie (Ulog) de l'amplificateur (10) ;
c) pour la compensation de température, il est prévu deux branches de circuit de courant (59, 63) à courant constant (I1, I2), avec chacune un composant (35, 41) dont la courbe caractéristique est identique à celle des premier et deuxième composants ainsi qu'un deuxième amplificateur différentiel (47) qui amplifie une valeur (Ud2), dérivée de la deuxième tension différentielle (ΔU_{2TC}) entre les noeuds d'entrée (61, 57) des deux composants (35, 41) placés dans les deux branches de circuit de courant (59, 63), pour former un signal d'erreur (F) ;
d) pour la première et la deuxième tension différentielle, il est prévu chaque fois un diviseur de tension (23, 25 ; 43, 45) commandé avec prise de tension partielle (27/29 ; 49/51), auquel le signal d'erreur (F) est transmis comme signal de commande et
e) le premier et le deuxième amplificateur différentiel (31, 47) sont connectés à la prise de tension du diviseur de tension commandé (27/49, 49/51) concerné.

2. Circuit amplificateur selon la revendication 1, **caractérisé en ce que** l'amplificateur est un amplificateur logarithmique (10) et les composants (19, 35, 41) à courbe caractéristique prédéterminée sont des diodes ou des transistors bipolaires.

3. Circuit amplificateur selon la revendication 1 ou 2, **caractérisé en ce que** chaque diviseur de tension commandé contient comme résistance variable (25, 45), un transistor MOSFET, dont la grille reçoit le signal d'erreur (F).

4. Circuit amplificateur selon la revendication 1 ou 2, **caractérisé en ce que** chaque diviseur de tension commandé est formé de plusieurs transistors MOSFET, dont les grilles reçoivent le signal d'erreur (F).

5. Circuit amplificateur selon une des revendications 1 à 4, **caractérisé en ce que** les premier et deuxième amplificateurs différentiels (31, 47) sont connectés chacun aux prises de tension partielle du diviseur de tension commandé (27/29, 49/51), une source à tension constante (65) indépendante de la température étant disposée dans la branche de circuit d'entrée du deuxième amplificateur différentiel (47).

6. Circuit amplificateur selon une des revendications 1 à 5, **caractérisé en ce que** l'une des deux branches de circuit de courant (59, 63) prévues pour la compensation de température est identique à la branche de circuit de courant de référence (59).

7. Circuit amplificateur selon une des revendications 1 à 6, **caractérisé en ce que** le composant (41) dans l'un des circuits de courant pour la compensation de température présente une surface de composant (a3) définie plus grande ou plus petite que le composant (35) dans l'autre desdits circuits de courant.
